# EUROPEAN PATENT APPLICATION

(11) **EP 3 219 393 A1**
(43) Date of publication of application: **20.09.2017**
(21) Application number: 15859112.3
(22) Date of filing: 20.10.2015
(51) Int. Cl.: B05B 5/053

(54) **ELECTROSTATIC SPRAY DEVICE, INSPECTION METHOD, INSPECTION PROGRAM, AND COMPUTER READABLE INFORMATION RECORDING MEDIUM**

(30) Priority: 10.11.2014 JP 2014228454
(71) Applicant: Sumitomo Chemical Company Limited, Tokyo 104-8260 (JP)
(72) Inventor: DAU, Van Thanh, Takarazuka-shi Hyogo 665-8555 (JP)
(74) Representative: Vossius & Partner Patentanwälte Rechtsanwälte mbB
(86) International application number: PCT/JP2015/079544
(87) International publication number: WO 2016/076081

(57) **Abstract**

The present invention provides an electrostatic atomizer which can be inspected at low cost. The electrostatic atomizer includes: a PWM signal generating section (27) which generates a PWM signal for controlling a high voltage generating device (22); an identifying section (28) which identifies an on-time of a PWM signal during a certain time; and a reporting section (33) which causes a report to be sent out of the electrostatic atomizer in a case where the on-time identified by the identifying section (28) is larger than a certain value.

## Description

### Technical Field

The present invention relates to (i) an electrostatic atomizer including a high voltage generating section that applies a high voltage between electrodes, (ii) a method for inspecting an electrostatic atomizer, (iii) an inspection program, and (iv) a computer-readable information recording medium.

### Background Art

Conventionally, an atomizer which sprays, via a nozzle, a liquid in a container has been widely used in various fields. A known example of such an atomizer is an electrostatic atomizer which atomizes and sprays a liquid by Electro Hydrodynamics (EHD). The electrostatic atomizer forms an electric field in the vicinity of a tip of a nozzle and uses the electric field to atomize and spray the liquid at the tip of the nozzle. Patent Literature 1 is known as a document which discloses such an electrostatic atomizer.

Such an electrostatic atomizer uses a high voltage generating device which (i) increases a voltage generated by a direct power supply and (ii) applies the increased voltage between electrodes. If there exists any defect such as defective soldering in a high voltage generating device, then an electric current consumption of an electrostatic atomizer becomes large. This accelerates battery power consumption. Therefore, in a production (inspection) step, inspection is carried out such that (i) an electric current consumption of a high voltage generating device is measured with the use of an ammeter and (ii) a high voltage generating device whose electric current consumption is equal to or greater than a certain value is judged as a defective product.

### Citation List

### [Patent Literature]

[Patent Literature 1] PCT International Publication No. WO2013/018477A1 (Publication Date: February 7, 2013)

### Summary of Invention

### Technical Problem

However, according to the inspection described above, it is necessary to use an ammeter for measuring an electric current consumption of a high voltage generating device. An inspecting method in which an electric current consumption is measured with the use of an ammeter causes an increase in (i) the number of processes involved for inspection and (ii) production cost.

The present invention has been made in view of the problem, and it is an object of the present invention to provide an electrostatic atomizer, an electrostatic atomizer inspecting method, an inspection program, and a computer-readable information recording medium, each of which allows inspection to be carried out at low cost.

### Solution to Problem

In order to attain the object, an electrostatic atomizer in accordance with an embodiment of the present invention includes a first electrode and a second electrode and sprays a liquid from a tip of the first electrode by applying a high voltage between the first electrode and the second electrode, the electrostatic atomizer including: a high voltage generating section for applying a high voltage between the first electrode and the second electrode; a signal generating section for generating a PWM signal (Pulse Width Modulation signal) for controlling the high voltage generating section so that an electric current at the second electrode is retained within a certain range; an identifying section for identifying an on-time of the PWM signal during a certain time; and a reporting section for causing a report to be sent out of the electrostatic atomizer in a case where the on-time identified by the identifying section is larger than a certain value, the report reporting that the on-time identified by the identifying section is larger than the certain value.

In order to attain the object, an inspecting method in accordance with an embodiment of the present invention is a method for inspecting an electrostatic atomizer including a first electrode and a second electrode and spraying a liquid from a tip of the first electrode by applying a high voltage between the first electrode and the second electrode, the electrostatic atomizer including: a high voltage generating section for applying a high voltage between the first electrode and the second electrode, the method including the steps of: (a) generating a PWM signal (Pulse Width Modulation signal) for controlling the high voltage generating section so that an electric current at the second electrode is retained within a certain range; (b) identifying an on-time of the PWM signal during a certain time; and (c) causing a report to be sent out of the electrostatic atomizer in a case where the on-time identified in the step (b) is larger than a certain value, the report reporting that the on-time identified in the step (b) is larger than the certain value.

According to the configurations, a PWM signal for controlling the high voltage generating section is generated by the signal generating section (in the step (a)). In addition, an on-time of the PWM signal during a certain time is identified by the identifying section (in the step (b)), and, by the reporting section (in the step (c)), a report reporting that the on-time is larger than a certain value is sent out of the electrostatic atomizer in a case where the on-time is larger than the certain value.

The inventors found that there is a certain relationship between (i) an amount of electric current consumption of a high voltage generating section and (ii) an on-time of a PWM signal, and that it is therefore possible to inspect an electrostatic atomizer based on the on-time of the PWM signal. Therefore, it is specified in advance that an electrostatic atomizer is a defective product in a case where, for example, an on-time is larger than a certain value. Hence, in the inspecting step of inspecting the electrostatic atomizer, selection of electrostatic atomizers which are good products from electrostatic atomizers which are defective products can be easily made with a decision-making factor of whether or not the reporting section gives a report.

That is, according to each of the electrostatic atomizer in accordance with an embodiment of the present invention and an inspecting method in accordance with an embodiment of the present invention, inspection is carried out by the signal generating section (in the step (a)), the identifying section (in the step (b)), and the reporting section (in the step (c)). This renders an ammeter unnecessary for carrying out inspection. With each of the electrostatic atomizer in accordance with an embodiment of the present invention and the inspecting method in accordance with an embodiment of the present invention, therefore, it is possible to reduce (i) the number of processes involved for inspection and (ii) production cost.

In order to attain the object, an electrostatic atomizer in accordance with an embodiment of the present invention includes a first electrode and a second electrode and sprays a liquid from a tip of the first electrode by applying a high voltage between the first electrode and the second electrode, the electrostatic atomizer including: a high voltage generating section for applying a high voltage between the first electrode and the second electrode; a signal generating section for generating a PWM signal (Pulse Width Modulation signal) for controlling the high voltage generating section so that an electric current at the second electrode is retained within a certain range; an identifying section for identifying an electric current consumption of the high voltage generating section on the basis of an on-time of the PWM signal in accordance with a relational formula in which an on-time of the PWM signal during a certain time and an electric current consumption of the high voltage generating section are associated with each other; and a reporting section for causing a report to be sent out of the electrostatic atomizer in a case where the electric current consumption of the high voltage generating section identified by the identifying section is larger than a value specified in advance, the report reporting that the electric current consumption of the high voltage generating section identified by the identifying section is larger than the value specified in advance.

According to the configuration, an electric current consumption of the high voltage generating section is identified by the identifying section. That is, according to the electrostatic atomizer in accordance with an embodiment of the present invention, an electric current consumption of the high voltage generating section is identified by the signal generating section and by the identifying section. This renders an ammeter unnecessary.

Therefore, with the electrostatic atomizer in accordance with an embodiment of the present invention, it is possible to reduce (i) the number of processes involved for inspection and (ii) production cost.

According to the configuration, the identifying section uses, when identifying the electric current consumption of the high voltage generating section, a relational formula in which an on-time of the PWM signal during a certain time and an electric current consumption of the high voltage generating section are associated with each other. This makes it easy to identify an electric current consumption.

For example, the certain value is defined in advance so that (i) the high voltage generating section is not a defective product if the electric current consumption is below the certain value and (ii) the high voltage generating section is a defective product if the electric current consumption is above the certain value. Hence, in the inspecting step of inspecting the high voltage generating section, for example, selection of high voltage generating sections which are good products from high voltage generating sections which are defective products can be easily made with a decision-making factor of whether or not the reporting section gives a report. This allows for a reduction in inspection cost.

Note that the electrostatic atomizers can each be achieved by a computer. In such a case, the scope of the present invention also encompasses (i) an inspection program for achieving, with the use of a computer, each of the electrostatic atomizers by causing the computer to serve as each of the sections and (ii) a computer-readable information recording medium in which the inspection program is recorded.

### Advantageous Effects of Invention

An electrostatic atomizer in accordance with an embodiment of the present invention includes: a high voltage generating section for applying a high voltage between a first electrode and a second electrode; a signal generating section for generating a PWM signal (Pulse Width Modulation signal) for controlling the high voltage generating section so that an electric current at the second electrode is retained within a certain range; an identifying section for identifying an on-time of the PWM signal during a certain time; and a reporting section for causing a report to be sent out of the electrostatic atomizer in a case where the on-time identified by the identifying section is larger than a certain value, the report reporting that the on-time identified by the identifying section is larger than the certain value.

An electrostatic atomizer in accordance with an embodiment of the present invention includes: a high voltage generating section for applying a high voltage between the first electrode and the second electrode; a signal generating section for generating a PWM signal (Pulse Width Modulation signal) for controlling the high voltage generating section so that an electric current at the second electrode is retained within a certain range; an identifying section for identifying an electric current consumption of the high voltage generating section on the basis of an on-time of the PWM signal during a certain time in accordance with a relational formula in which an on-time of the PWM signal during a certain time and an electric current consumption of the high voltage generating section are associated with each other; and a reporting section for causing a report to be sent out of the electrostatic atomizer in a case where the electric current consumption of the high voltage generating section identified by the identifying section is larger than a value specified in advance, the report reporting that the electric current consumption of the high voltage generating section identified by the identifying section is larger than the value specified in advance.

An electrostatic atomizer inspecting method in accordance with an embodiment of the present invention includes the step of: (a) generating a PWM signal (Pulse Width Modulation signal) for controlling the high voltage generating section so that an electric current at a second electrode is retained within a certain range; (b) identifying an on-time of the PWM signal during a certain time; and (c) causing a report to be sent out of the electrostatic atomizer in a case where the on-time identified in the step (b) is larger than a certain value, the report reporting that the on-time identified in the step (b) is larger than the certain value.

Therefore, each of the electrostatic atomizers and the inspecting method in accordance with embodiments of the present invention advantageously makes it possible to inspect a high voltage generating section at low cost.

### Brief Description of Drawings

Fig. 1 is a view for describing an appearance of an electrostatic atomizer in accordance with an embodiment of the present invention.
Fig. 2 is a view for describing a spray electrode and a reference electrode.
Fig. 3 is a block diagram illustrating a configuration of the electrostatic atomizer in accordance with the embodiment of the present invention.
Fig. 4 is a graph showing a relationship between an electric current consumption and an on-time of a PWM signal during a certain time.
Fig. 5 is a reference diagram for describing another method for measuring an electric current consumption of a high voltage generating device.
Fig. 6 is a block diagram illustrating a configuration of an electrostatic atomizer in accordance with Example 1 of the present invention.
Fig. 7 is a block diagram illustrating a configuration of an electrostatic atomizer in accordance with Example 2 of the present invention.
Fig. 8 is a block diagram illustrating a configuration of an electrostatic atomizer in accordance with Example 3 of the present invention.
Fig. 9 is a block diagram illustrating a configuration of an electrostatic atomizer in accordance with Example 4 of the present invention.

### Description of Embodiments

An electrostatic atomizer 100 in accordance with an embodiment of the present invention is a device including a spray electrode 1 (first electrode) and a reference electrode 2 (second electrode) and is configured to spray a liquid from a tip of the spray electrode 1 by applying a high voltage between the spray electrode 1 and the reference electrode 2.

The electrostatic atomizer 100 includes: a high voltage generating device 22 (high voltage generating section) for applying a high voltage between the spray electrode 1 and the reference electrode 2; a PWM signal generating section 27 (signal generating section) for generating a PWM signal (Pulse Width Modulation signal) for controlling the high voltage generating device 22 so that an electric current at the reference electrode 2 is retained within a certain range; an identifying section 28 for identifying an on-time of the PWM signal during a certain time; and a reporting section 33 for causing a report to be sent out of the electrostatic atomizer in a case where the on-time identified by the identifying section 28 is larger than a certain value, the report reporting that the on-time identified by the identifying section is larger than the certain value.

The following description will discuss the electrostatic atomizer 100 in accordance with an embodiment of the present invention.

### [Electrostatic atomizer 100]

The electrostatic atomizer 100 in accordance with an embodiment will be described below with reference to the drawings. In the following description, (i) identical members and identical constituent elements are given identical reference signs and (ii) the identical members and the identical constituent elements have identical names and identical functions. Therefore, detailed descriptions of the identical members and the identical constituent elements will not be repeated.

The electrostatic atomizer 100 is to be used for, for example, spraying aromatic oil, a chemical substance for an agricultural product, a medicine, an agricultural chemical, a pesticide, an air cleaning agent, and the like. The electrostatic atomizer 100 includes a spray electrode 1, a reference electrode 2, and a power supply device 3.

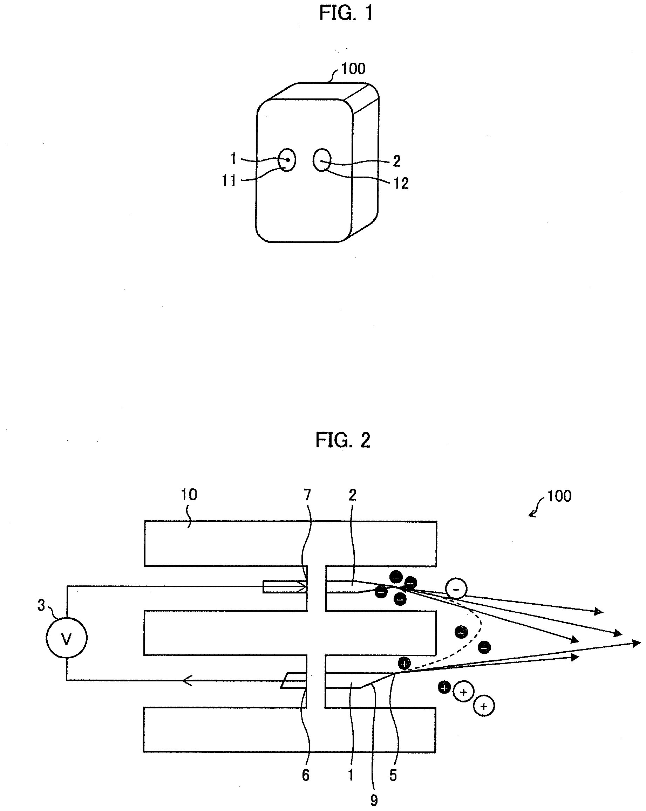

An appearance of the electrostatic atomizer 100 will be first described with reference to Fig. 1. Fig. 1 is a view for describing the appearance of the electrostatic atomizer 100.

As illustrated in Fig. 1, the electrostatic atomizer 100 has a rectangular parallelepiped shape. The spray electrode 1 and the reference electrode 2 are provided on one surface of the electrostatic atomizer 100. The spray electrode 1 is provided in the vicinity of the reference electrode 2. Further, a circular opening 11 and a circular opening 12 are provided so as to surround the spray electrode 1 and the reference electrode 2, respectively.

A voltage is applied between the spray electrode 1 and the reference electrode 2, so that an electric field is formed between the spray electrode 1 and the reference electrode 2. The spray electrode 1 sprays a positively charged droplet. The reference electrode 2 ionizes and negatively charges air in the vicinity of the reference electrode 2. Then, the negatively charged air moves away from the reference electrode 2, due to (i) the electric field formed between the spray electrode 1 and the reference electrode 2 and (ii) a repulsive force among particles of the negatively charged air. This movement creates an air flow (hereinafter, also referred to as an ion stream), and the positively charged droplet is sprayed in a direction away from the electrostatic atomizer 100 due to the ion stream.

The shape of the electrostatic atomizer 100 is not limited to the rectangular parallelepiped shape but can be another shape. The shape of each of the opening 11 and the opening 12 can be a shape other than a circular shape. The opening 11 and the opening 12 can each have an opening size which is adjusted as appropriate.

### [Spray electrode 1 and reference electrode 2]

The spray electrode 1 and the reference electrode 2 will be described below with reference to Fig. 2. Fig. 2 is a view for describing the spray electrode 1 and the reference electrode 2.

The spray electrode 1 includes a conductive conduit such as a metallic capillary (e.g., type 304 stainless steel), and a tip 5 which is a tip of the spray electrode 1. The spray electrode 1 is electrically connected with the reference electrode 2 via the power supply device 3. The spray electrode 1 sprays a substance to be atomized (hereinafter referred to as "liquid") from the tip 5. The spray electrode 1 has an inclined plane 9, which inclines with respect to an axial center of the spray electrode 1 and has a shape that becomes thinner and sharper toward the tip 5 of the spray electrode 1.

The reference electrode 2 includes a conductive rod such as a metal pin (e.g., type 304 steel pin). The spray electrode 1 and the reference electrode 2 are provided parallel so as to be spaced apart from each other with a certain distance therebetween. The spray electrode 1 and the reference electrode 2 are provided so as to be spaced apart from each other by a distance of, for example, 8 mm.

The power supply device 3 is provided for applying a high voltage between the spray electrode 1 and the reference electrode 2. For example, the power supply device 3 applies a high voltage of 1 kV to 30 kV (e.g., 5 kV to 6 kV) between the spray electrode 1 and the reference electrode 2. In a case where a high voltage is applied between the spray electrode 1 and the reference electrode 2, an electric field is formed between the spray electrode 1 and the reference electrode 2. This causes an electric dipole to be generated inside a dielectric 10. In so doing, the spray electrode 1 is positively charged, and the reference electrode 2 is negatively charged (alternatively, the spray electrode 1 can be negatively charged, and the reference electrode 2 can be positively charged). Then, a negative dipole occurs on a surface of the dielectric 10 which surface is the closest to the spray electrode 1 that is positively-charged, and a positive dipole occurs on a surface of the dielectric 10 which surface is the closest to the reference electrode 2 that is negatively-charged, so that a charged gas and a charged substance species are released by the spray electrode 1 and the reference electrode 2.

As described above, an electric charge generated by the reference electrode 2 has a polarity opposite a polarity of a liquid. Therefore, the electric charge of the liquid is equilibrated by an electric charge generated by the reference electrode 2. This allows the electrostatic atomizer 100 to stably carry out spraying, based on the principle of charge equilibration.

Note that the international standard developed by the International Electrotechnical Commission (IEC) defines that (i) a voltage of 1500 V or higher is a high voltage in a case of a direct current and (ii) a voltage of 1000 V or higher is a high voltage in a case of an alternating current.

The dielectric 10 is made of a dielectric material such as nylon 6, nylon 11, nylon 12, polypropylene, nylon 66, or a polyacetyl-polytetrafluoroethylene mixture. The dielectric 10 supports the spray electrode 1 at a spray electrode mounting section 6 and also supports the reference electrode 2 at a reference electrode mounting section 7.

### [Power supply device 3]

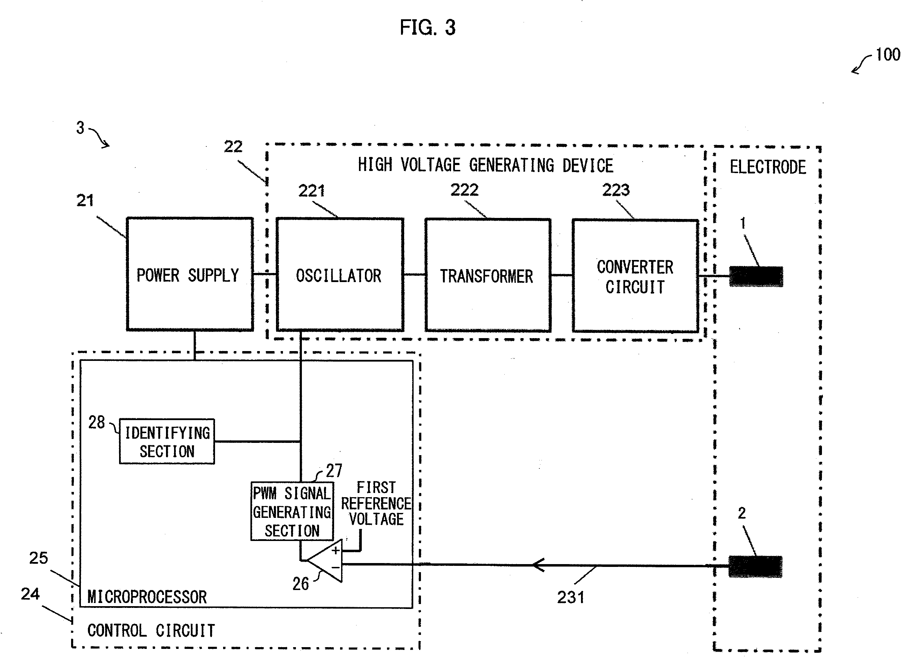

Fig. 3 is a block diagram illustrating a configuration of the electrostatic atomizer 100.

As illustrated in Fig. 3, the electrostatic atomizer 100 includes, as the power supply device 3, the following: a power supply 21, the high voltage generating device 22, a current feedback circuit 231, and a control circuit 24.

### [Power supply 21]

The power supply 21 supplies a power necessary for operating the electrostatic atomizer 100. The power supply 21 can be a well-known power supply, and can be any of a direct power supply and an alternating power supply. The power supply 21 is preferably a low-voltage power supply and/or a direct current (DC) power supply. The power supply 21 is obtained by, for example, combining one or more voltaic cells. Preferable examples of the battery encompass an alkaline dry cell and a lithium battery. The power supply 21 supplies a direct-current voltage to an oscillator 221 of the high voltage generating device 22.

### [High voltage generating device 22]

The high voltage generating device 22 generates a high voltage by increasing a voltage supplied from the power supply 21, and applies the high voltage between the spray electrode 1 and the reference electrode 2. The high voltage generating device 22 includes the oscillator 221, a transformer 222, and a converter circuit 223.

The oscillator 221 converts a direct current into an alternating current. To the oscillator 221, the transformer 222 is connected. To the oscillator 221, a PWM signal (typically a PWM signal having a duty ratio of approximately 2%) generated by the control circuit 24 is supplied.

The transformer 222 changes a voltage of an alternating current. To the transformer 222, the converter circuit 223 is connected. The converter circuit 223 generates a desired voltage, and converts an alternating current into a direct current. Ordinarily, the converter circuit 223 includes a charge pump and a rectifier circuit. The converter circuit is typically a Cockcroft-Walton circuit.

### [Current feedback circuit 231]

The current feedback circuit 231 measures an electric current at the reference electrode 2. Since the electrostatic atomizer 100 is charge equilibrated, measurement of an electric current at the reference electrode 2 and reference to the electric current allows for accurate monitoring of the electric current at the spray electrode 1.

The current feedback circuit 231 supplies, to a comparator 26 of the control circuit 24, a voltage value which corresponds to the electric current at the reference electrode 2 and serves as feedback information.

### [Control circuit 24]

The control circuit 24 supplies a PWM signal (pulse-width modulated signal) to the oscillator 221. This controls an operating state of the high voltage generating device 22. A PWM signal is a pulse signal cyclically switching between an on-voltage state and an off-voltage state. A value obtained by accumulating times during which a PWM signal is in an on-voltage state within a predetermined period (certain time) is herein referred to as "on-time of a PWM signal".

A ratio of a period during which a PWM signal is in an on-voltage state to a single cycle (or certain period) of the PWM signal will be referred to as "duty ratio" of the PWM signal.

Therefore, in a case where the predetermined time is sufficiently long relative to a single cycle of the PWM signal, the on-time of the PWM signal is substantially proportional to the duty ratio of the PWM signal. Although an error which depends on a starting time point and an ending time point of the predetermined period with respect to a cycle of the PWM signal may occur, the following, for example, are true: (i) In a case where the duty ratio is 0.01 (1%), the on-time of the PWM signal during 1 second is approximately 0.01 seconds and (ii) In a case where the duty ratio is 0.02 (2%), the on-time of the PWM signal during 1 second is approximately 0.02 seconds.

For various practical applications the control circuit 24 includes a microprocessor 25. The microprocessor 25 can be PIC16F1825 produced by Microchip.

The microprocessor 25 includes the comparator 26, the PWM signal generating section 27, and an identifying section 28.

The comparator 26 includes a negative terminal, a positive terminal, and an output terminal. In a case where a voltage supplied to the negative terminal is larger than a voltage supplied to the positive terminal, a low voltage (voltage V1) is outputted from the output terminal. In contrast, in a case where a voltage supplied to the negative terminal is equal to or less than a voltage supplied to the positive terminal, a high voltage (voltage V2; V1<V2) is outputted from the output terminal.

To the negative terminal of the comparator 26, a voltage corresponding to an electric current at the reference electrode 2 is supplied. To the positive terminal of the comparator 26, a first reference voltage, which is a predetermined and constant voltage, is supplied. The output terminal of the comparator 26 is connected to the PWM signal generating section 27 so that an output from the comparator 26 is supplied to the PWM signal generating section 27.

Therefore, in a case where a voltage corresponding to an electric current at the reference electrode 2 is larger than a first reference voltage, a low voltage (V1) is supplied from the comparator 26 to the PWM signal generating section 27. In a case where a voltage corresponding to an electric current at the reference electrode 2 is equal to or less than a first reference voltage, a high voltage (V2) is supplied from the comparator 26 to the PWM signal generating section 27.

Based on the output from the comparator 26, the PWM signal generating section 27 adjusts a duty ratio of a PWM signal. Then, the PWM signal generating section 27 supplies the PWM signal to the oscillator 221 and to the identifying section 28.

Specifically, in a case where a voltage corresponding to an electric current at the reference electrode 2 is larger than a first reference voltage, a low voltage is supplied from the comparator 26 to the PWM signal generating section 27. In this case, the PWM signal generating section 27 supplies, to the oscillator 221 and to the identifying section 28, a PWM signal having a duty ratio smaller than a duty ratio of a PWM signal which is being outputted. Meanwhile, in a case where a voltage corresponding to an electric current at the reference electrode 2 is equal to or less than a first reference voltage, a high voltage is supplied from the comparator 26 to the PWM signal generating section 27. In this case, the PWM signal generating section 27 supplies, to the oscillator 221 and to the identifying section 28, a PWM signal having a duty ratio larger than a duty ratio of a PWM signal which is being outputted.

The PWM signal generating section 27 thus adjusts a duty ratio of a PWM signal, based on the output from the comparator 26, and then supplies the PWM signal to the oscillator 221 and to the identifying section 28. This causes an operating state of the high voltage generating device 22 (the oscillator 221, the transformer 222, and the converter circuit 223) to be associated with an on-time of the PWM signal during a certain time.

Based on the PWM signal supplied from the PWM signal generating section 27, the identifying section 28 identifies an on-time (integrated value) of the PWM signal during a certain time. Based on the on-time (integrated value) of the PWM signal during the certain time, the identifying section 28 identifies an electric current consumption of the high voltage generating device 22. The details will be described later.

Note that a frequency and a timing, with which the comparator 26 outputs a low voltage or a high voltage depending on a result of comparison between a voltage corresponding to an electric current at the reference electrode 2 and a first reference voltage, can be set in advance. Alternatively, the frequency and the timing can be set as appropriate by the microprocessor 25.

The a range, by which a duty ratio is increased or decreased in a case where the PWM signal generating section 27 adjusts the duty ratio based on the output from the comparator 26, can be set in advance. Alternatively, the range can be set as appropriate by the microprocessor 25. The control circuit 24 can use a subtractor instead of the comparator 26. The PWM signal generating section 27 can adjust the duty ratio by an increasing/decreasing range corresponding to the output from the subtractor.

The microprocessor 25 thus monitors, at a frequency set in advance, a voltage value corresponding to an electric current at the reference electrode 2. Then, in a case where a voltage applied between the spray electrode 1 and the reference electrode 2 is reduced and therefore a voltage corresponding to the electric current at the reference electrode 2 becomes equal to or less than a first reference voltage, an output voltage of the comparator 26 switches from a low voltage to a high voltage. This causes the PWM signal generating section 27 to increase a duty ratio of a PWM signal by a range which was set in advance. In a case where the PWM signal generating section 27 increases the duty ratio of the PWM signal, a high voltage generated by the high voltage generating device 22 increases. This causes a voltage applied between the spray electrode 1 and the reference electrode 2 to increase.

Note that a first reference voltage supplied to the comparator 26 is set in advance so that (i) a voltage to be applied between the spray electrode 1 and the reference electrode 2 falls within a proper range (e.g. 5 kV to 6 kV) and (ii) an electric current at the reference electrode 2 is retained at 0.87 µA.

Specifically, based on a voltage corresponding to an electric current at the reference electrode 2, the control circuit 24 generates a PWM signal whose duty ratio is adjusted so that the electric current flowing across the reference electrode 2 is 0.87 µA. Then, based on the PWM signal, the high voltage generating device 22 adjusts a voltage between the spray electrode 1 and the reference electrode 2.

Note that a PWM signal can be generated so that an electric current at the reference electrode 2 is, instead of being at a certain value such as 0.87 µA, retained in a certain range (e.g. 0.85 µA or more and 0.90 µA or less).

Although the microprocessor 25 is configured to include the comparator 26 and the PWM signal generating section 27 in the description above, the present invention is not limited to this configuration. Alternatively, it is possible that the microprocessor 25 does not include a comparator 26 and that the PWM signal generating section 27 is equipped with a function to compare between a voltage corresponding to an electric current at the reference electrode 2 and a first reference voltage.

Although the description above exemplified a configuration in which a lower limit of a voltage corresponding to an electric current at the reference electrode 2 is set and controlled by use of the comparator 26 that compares between the voltage and a first reference voltage, the present invention is no limited to this configuration. It is also possible to set and control an upper limit of a voltage corresponding to an electric current at the reference electrode 2 by further using a comparator that compares between the voltage and a third reference voltage.

### <Electric current consumption of high voltage generating device 22 >

The inventors of the present invention found that there is a certain relationship between (i) an amount of electric current consumption of the high voltage generating device 22 and (ii) an on-time of a PWM signal generated based on current feedback control.

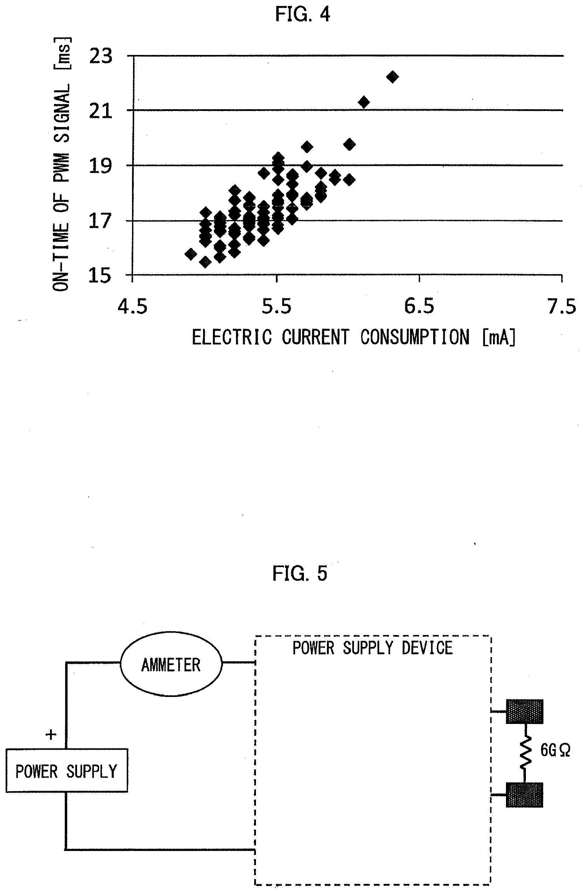

Fig. 4 is a graph showing a relationship between electric current consumption and an on-time of the PWM signal during a certain time (1.024 seconds).

As illustrated in Fig. 4, the on-time of the PWM signal is substantially proportional to the electric current consumption. This is because of the following reason: In a case where an electric current consumption of the high voltage generating device 22 is large due to, for example, defective soldering (cold solder), an impedance of the high voltage generating device 22 becomes large. This makes it necessary to control a voltage, which is to be applied between the spray electrode 1 and the reference electrode 2, to be high so that an electric current at the reference electrode 2 is retained at a certain value (within a certain range). As a result, a duty ratio of a PWM signal generated by the PWM signal generating section 27 increases, and, proportionally to the increase in the duty ratio of the PWM signal, the on-time of the PWM signal during the certain time increases.

Therefore, an electric current consumption can be identified (estimated) based on an on-time of the PWM signal by (i) measuring, in advance, both the on-time of the PWM signal and an electric current consumption of the high voltage generating device 22 and (ii) associating the on-time of the PWM signal with the electric current consumption. Note that where an on-time of the PWM signal is expressed as x and an electric current consumption of the high voltage generating device 22 is expressed as y, a relationship between x and y can be expressed by the following relational formula (linear function): y=ax+b (a and b are any constant).

Then, since the control circuit 24 of the electrostatic atomizer 100 includes the identifying section 28, the electric current consumption of the high voltage generating device 22 can be identified based on the on-time of the PWM signal generated by current feedback control.

As described above, the electrostatic atomizer 100 includes the current feedback circuit 231 and the control circuit 24. It is therefore possible to achieve an electric current consumption identifying method which includes the step of (i) generating, by use of the PWM signal generating section 27, a PWM signal whose duty ratio is adjusted so that an electric current at the reference electrode 2 is retained at a certain value (within a certain range) (signal generating step) and (ii) identifying, by use of the identifying section 28, an electric current consumption of the high voltage generating device 22 based on an on-time of the PWM signal (identifying step).

With the configuration above, it is possible to inspect the high voltage generating device 22 at low cost, and to carrying out highly reliable inspection without being affected by measurement accuracy of another device (e.g. ammeter) for identifying an electric current consumption.

With the electrostatic atomizer 100 in accordance with the present embodiment, an electric current consumption of the high voltage generating device 22 can be inspected without storing, in the electrostatic atomizer 100, a liquid to be sprayed, as is the case where the electrostatic atomizer 100 is actually used. This allows even an electrostatic atomizer 100, which has been subjected to inspection of an electric current consumption of a high voltage generating device 22, to be shipped as an unused product. The method for identifying an electric current consumption and the method for inspection are effective particularly for an electrostatic atomizer which sprays a liquid.

In addition, with the electrostatic atomizer 100 in accordance with the present embodiment, it is possible to inspect an electric current consumption of the high voltage generating device 22 while a liquid to be sprayed is stored in the electrostatic atomizer 100 as is the case where the electrostatic atomizer 100 is actually used. This makes it possible to inspect an electric current consumption of the high voltage generating device 22 even after a user has used the electrostatic atomizer 100.

### <Reference Example>

Fig. 5 is a reference diagram for describing another method for measuring an electric current consumption of a high voltage generating device.

It is possible that a device including a resistance (e.g. typical resistance of 6 G Ω) between electrodes as illustrated in Fig. 5 can be configured so that an electric current consumption of a power supply device is measured by providing an ammeter between a power supply and the power supply device, connecting the ammeter to the power supply and to the power supply device, and measuring an electric current value.

However, in a case where an electric current consumption is measured by use of an ammeter, it is necessary to connect the ammeter between devices in a circuit. This causes (i) an increase in the number of processes involved for inspection and (ii) an increase in cost. In addition, since results of inspection are affected by measurement accuracy of the ammeter, the results are subject to the quality of the ammeter as a product. The results can therefore not be said to be sufficiently reliable.

Meanwhile, an electric current consumption of the electrostatic atomizer 100 in accordance with the present embodiment is measured based on the principle that an on-time of the PWM signal is measured, and then the electric current consumption of the high voltage generating device 22 is identified based on the on-time of the PWM signal. A more specific configuration of the control circuit 24 in accordance with the present embodiment will be described below with reference to Examples 1 through 3.

### <Example 1>

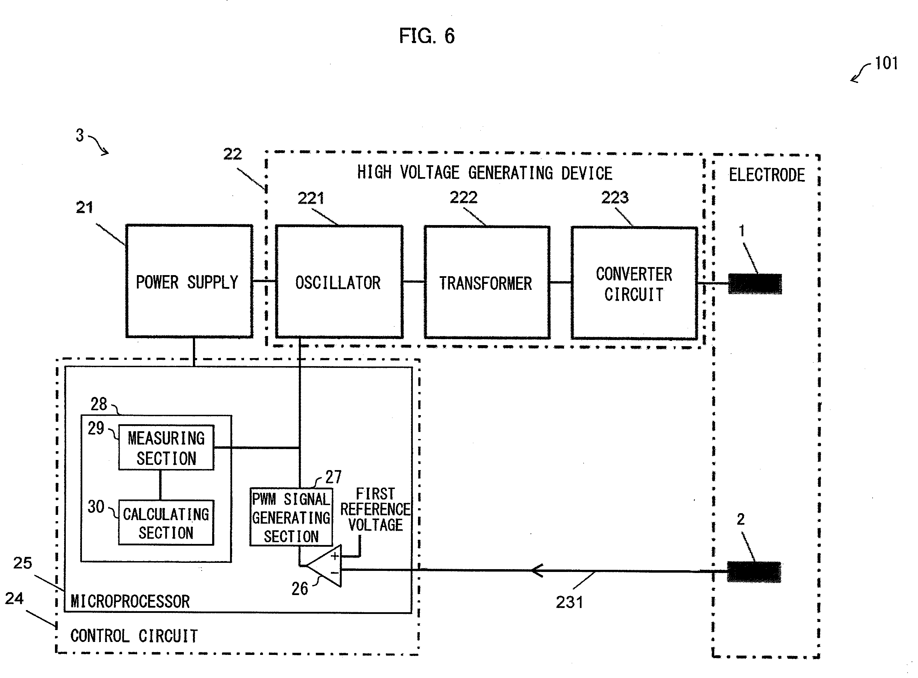

Fig. 6 is a block diagram illustrating a configuration of an electrostatic atomizer 101 in accordance with Example 1. As illustrated in Fig. 6, an identifying section 28 of the electrostatic atomizer 101 includes a measuring section 29 and a calculating section 30. The measuring section 29 measures an on-time of the PWM signal, and then supplies information on the on-time to the calculating section 30. Based on the information on the on-time supplied from the measuring section 29, the calculating section 30 calculates an electric current consumption of a high voltage generating device 22.

As described above with reference to Fig. 4, an electric current consumption of the high voltage generating device 22 and an on-time of the PWM signal are proportional to each other. The calculating section 30 stores a relational formula in which the electric current consumption of the high voltage generating device 22 and the on-time of the PWM signal are associated with each other. In accordance with the relational formula, the calculating section 30 calculates the electric current consumption of the high voltage generating device 22 based on the on-time of the PWM signal. With the configuration, it is possible to easily calculate an electric current consumption of the power supply device 3.

As necessary, the identifying section 28 can include a data recording section for recording information on an on-time obtained by the measuring section 29.

### <Example 2>

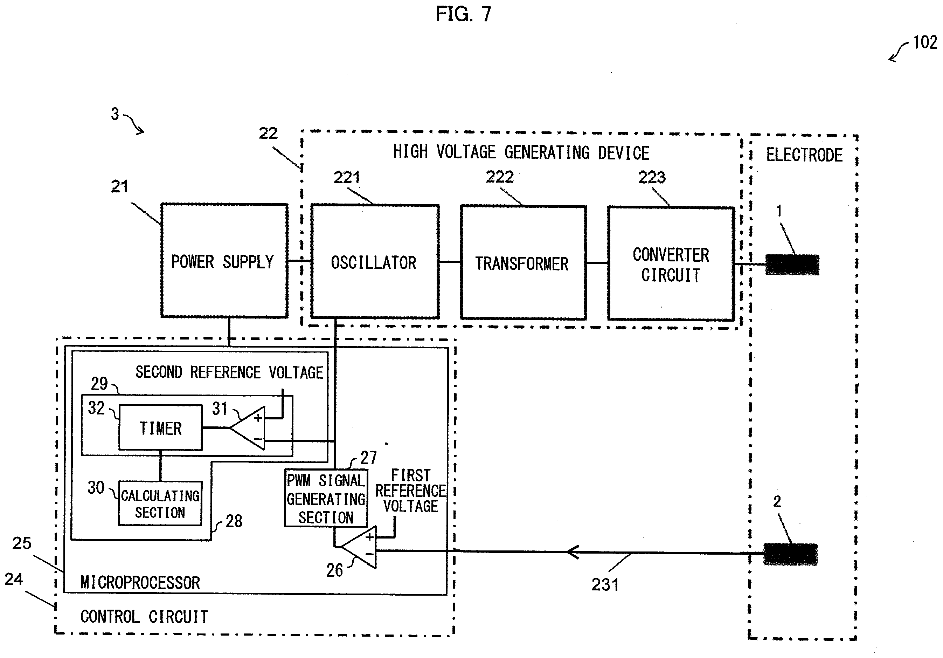

Fig. 7 is a block diagram illustrating a configuration of an electrostatic atomizer 102 in accordance with Example 2. As illustrated in Fig. 7, a measuring section 29 of the electrostatic atomizer 102 includes a comparator 31 and a timer 32. The comparator 31 includes a negative terminal, a positive terminal, and an output terminal. In a case where (results of a comparison shows that) a voltage supplied to the negative terminal is larger than a voltage supplied to the positive terminal, the comparator 31 outputs a low voltage (voltage V3) from the output terminal. In a case where a voltage supplied the negative terminal is equal to or less than a voltage supplied to the positive terminal, the comparator 31 outputs a high voltage (voltage V4; V3<V4) from the output terminal.

To the positive terminal (first input terminal) of the comparator 31, a second reference voltage is supplied. To the negative terminal (second input terminal) of the comparator 31, a PWM signal generated by a PWM signal generating section 27 is supplied. The second reference voltage can be any electric potential between an on-electric potential and an off-electric potential of a PWM signal, and can be decided as appropriate according to a waveform of the PWM signal. That is, the second reference voltage is a certain voltage corresponding to a threshold by which it is judged whether or not the PWM signal is in an on state.

The output terminal of the comparator 31 is connected to the timer 32, so that an output from the comparator 31 is supplied to the timer 32.

Based on the output from the comparator 31, the timer 32 measures an on-time of a PWM signal during a certain time (monitoring period). Specifically, the timer 32 monitors, at certain time intervals (clock cycle), whether an output voltage from the comparator 31 is a low voltage or a high voltage. Then, the timer 32 judges that (i) a period in which an output voltage of the comparator 31 is a low voltage is a period (on-time) in which the PWM signal has an on-electric potential and (ii) a period in which an output voltage of the comparator is a high voltage is a period in which the PWM signal has an off-electric potential.

A measurement resolution by which the on-time is measured depends on the clock cycle and the monitoring period of the timer 32. A shorter clock cycle and a longer monitoring period result in an increased measurement resolution. In Example 2, the clock cycle is 8 microseconds, and the monitoring period is 1.024 seconds.

With the configuration, the on-time of the PWM signal can be measured by simply including the timer 32 and the comparator 31.

### <Example 3>

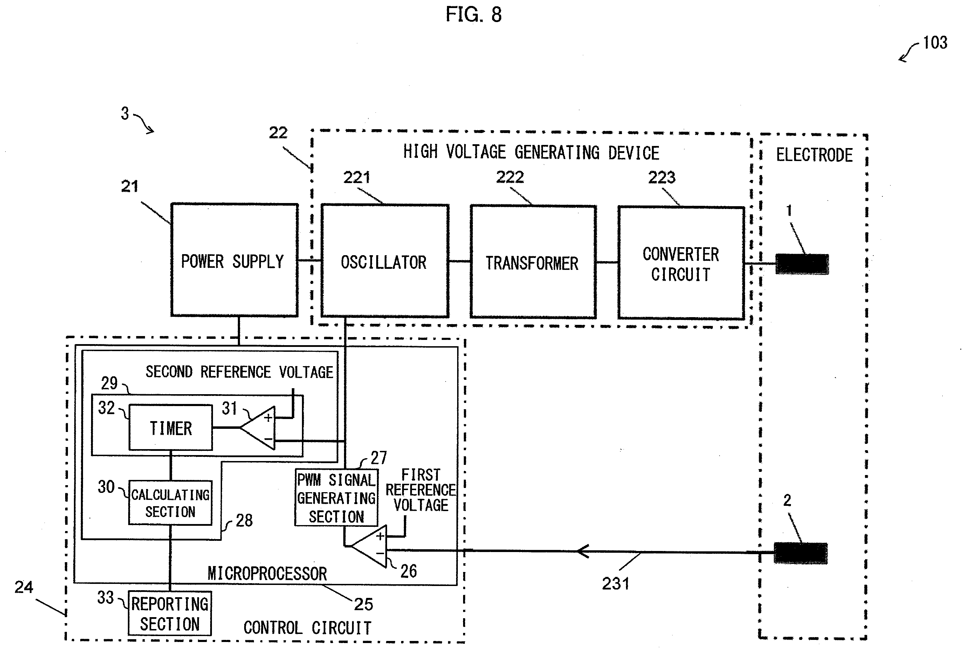

Fig. 8 is a block diagram illustrating a configuration of an electrostatic atomizer 103 in accordance with Example 3. As illustrated in Fig. 8, a control circuit 24 of the electrostatic atomizer 103 includes a reporting section 33.

The reporting section 33 can be configured so that in a case where an electric current consumption of a high voltage generating device 22 is larger than a certain value, the reporting section 33 gives a report to an inspecting worker outside the electrostatic atomizer 103 that the electric current consumption is larger than the certain value, that is, the reporting section 33 gives the report via at least any one of the following: making sound; displaying on a display member; turning on light; and flashing light.

Specifically, the reporting section 33 is connected to, for example, a speaker, a light such as an LED, or a display section (monitor), and controls the speaker, the light such as an LED, or the display section to give a report of the results of inspection. The calculating section 30 then supplies, to the reporting section 33, information on the electric current consumption of the high voltage generating device 22.

In a case where a report is given by the reporting section 33 in an inspecting step carried out by the electrostatic atomizer 103, it is possible to judge that at least any one selected from the group consisting of an oscillator 221, a transformer 222, and a converter circuit 223 is defective.

It is empirical knowledge that an electric current consumption of the high voltage generating device 22 is particularly largely affected by the transformer 222. Therefore, in a case where the electric current consumption of the high voltage generating device 22 is larger than a certain value in the inspecting step carried out by the electrostatic atomizer 103, the reporting section 33 gives, to an inspecting worker, a report that the electric current consumption is larger than the certain value, that is, the reporting section 33 gives the report via a speaker, a light such as an LED, or a display section. This allows the inspecting worker to regard the report by the reporting section 33 as an occasion to replace the transformer 222. Note that in a case where a report is made by the reporting section 33, an inspecting worker can judge that the oscillator 221 or the converter circuit 223 is defective, so as to replace the oscillator 221 or converter circuit 223.

The reporting section 33 can be configured so that in a case where an electric current consumption of a high voltage generating device 22 is smaller than a certain value, the reporting section 33 gives a report to an inspecting worker outside the electrostatic atomizer 103 that the electric current consumption is smaller than the certain value, that is, the reporting section 33 gives the report via at least any one of the following: making sound; displaying on a display member; turning on light; and flashing light.

In a case where the electric current consumption of the high voltage generating device 22 is so small as to fall outside a normal range, it can be deemed that there is a defect in, for example, the identifying section 28 and/or the PWM signal generating section 27 any of which is a circuit (sensor section for identifying the electric current consumption) included in the microprocessor 25. Therefore, in a case where the electric current consumption of the high voltage generating device 22 is smaller than a certain value in the inspecting step carried out by the electrostatic atomizer 103, the reporting section 33 gives, to an inspecting worker, a report that the electric current consumption is smaller than the certain value, that is, the reporting section 33 gives the report via a speaker, a light such as an LED, or a display section. This allows the inspecting worker to regard the report by the reporting section 33 as an occasion to replace the microprocessor 25. This allows the inspecting worker to regard the report by the reporting section 33 as an occasion to replace the microprocessor 25.

### <Example 4>

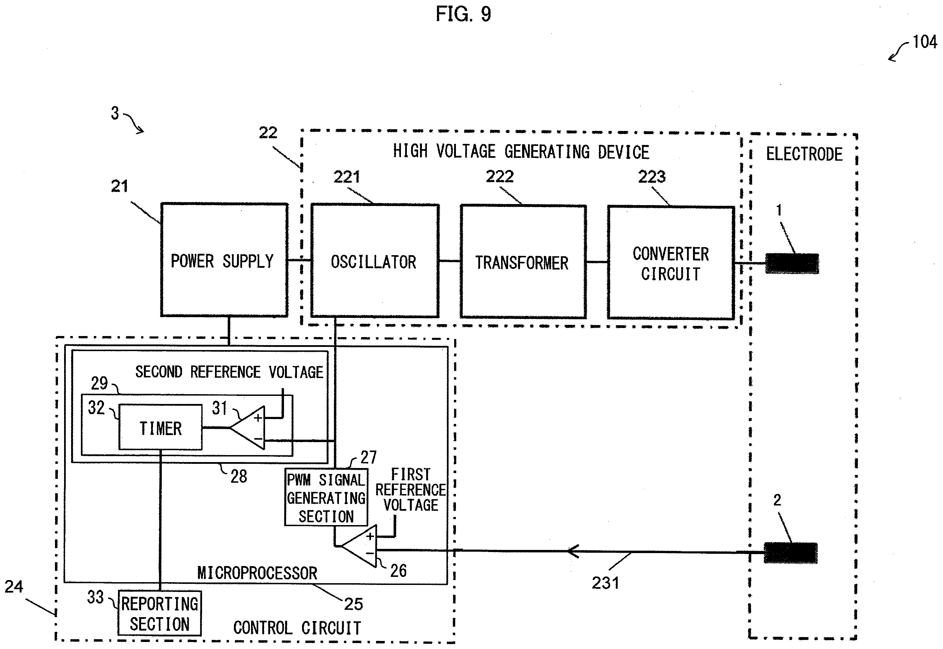

Fig. 9 is a block diagram illustrating a configuration of an electrostatic atomizer 104 in accordance with Example 4. As illustrated in Fig. 9, an identifying section 28 of the electrostatic atomizer 104 does not include a calculating section 30.

In a case where an on-time of an PWM signal measured by the timer 32 is larger than a certain value, the reporting section 33 gives a report to an inspecting worker outside the electrostatic atomizer 104 that the electric current consumption is larger than the certain value, that is, the reporting section 33 gives the report via at least any one of the following: making sound; displaying on a display member; turning on light; and flashing light (reporting step).

Specifically, the reporting section 33 is connected to, for example, a speaker, a light such as an LED, or a display section (monitor), and controls the speaker, the light such as an LED, or the display section to give a report of the results of inspection.

In a case where a report is given by the reporting section 33 in an inspecting step carried out by the electrostatic atomizer 103, it is possible to judge that at least any one selected from the group consisting of an oscillator 221, a transformer 222, and a converter circuit 223 is defective.

Even in a case where, as is the case of the electrostatic atomizer 104 in accordance with Example 4, an identifying section 28 does not include a calculating section, an electric current consumption can be still inspected.

Specifically, it is specified in advance that (i) in a case where an on-time of a PWM signal identified by the identifying section 28 (timer 32) is below a certain value, the high voltage generating device 22 is a good product whose electric current consumption does not exceed a predetermined electric current consumption and (ii) in a case where the on-time of the PWM signal is above the certain value, the high voltage generating device 22 is a defective product whose electric current consumption exceeds the predetermined electric current consumption.

Note that a certain value of an on-time of a PWM signal in Example 4 refers to a value corresponding, in a relational formula indicating a relationship between an on-time of a PWM signal and an electric current consumption of the high voltage generating device 22, to a predetermined electric current consumption in an inspecting step.

Hence, in the inspecting step of inspecting the electrostatic atomizer 104, selection of high voltage generating devices 22 which are good products from high voltage generating devices 22 which are defective products can be easily made with a decision-making factor of whether or not the reporting section 33 gives a report. This allows for a reduction in inspection cost.

### [Software Implementation Example]

Control blocks of the control circuit 24 (particularly identifying section 28) can be realized by a logic circuit (hardware) provided in an integrated circuit (IC chip) or the like or can be alternatively realized by software as executed by a central processing unit (CPU).

In the latter case, the control circuit 24 includes a CPU that executes instructions of a program (inspection program) that is software realizing the foregoing functions; a read only memory (ROM) or a storage device (each referred to as "information recording medium") in which the program and various kinds of data are stored so as to be readable by a computer (or a CPU); and a random access memory (RAM) in which the program is loaded. An object of the present invention can be achieved by a computer (or a CPU) reading and executing the program stored in the information recording medium. Examples of the information recording medium encompass "a non-transitory tangible medium" such as a tape, a disk, a card, a semiconductor memory, and a programmable logic circuit. The program can be supplied to the computer via any transmission medium (such as a communication network or a broadcast wave) which allows the program to be transmitted. Note that the present invention can also be achieved in the form of a computer data signal in which the program is embodied via electronic transmission and which is embedded in a carrier wave.

### [Other remarks]

Other configurations encompassed by the present invention will be described below.

In order to attain the object, an electric current consumption identifying device in accordance with an aspect of the present invention is an electric current consumption identifying device for identifying an electric current consumption of a high voltage generating section that applies a high voltage between electrodes,
the electric current consumption identifying device including:
a signal generating section for generating a PWM signal (Pulse Width Modulation signal) for controlling the high voltage generating section so that an electric current at one of the electrodes is retained within a certain range; and
an identifying section for identifying an electric current consumption of the high voltage generating section on the basis of an on-time of the PWM signal generated by the signal generating section.

In order to attain the object, an electric current consumption identifying method in accordance with an aspect of the present invention is a method for identifying electric current consumption of a high voltage generating section that applies a high voltage between electrodes,
the method including the steps of:
(a) generating a PWM signal (Pulse Width Modulation signal) for controlling the high voltage generating section so that an electric current at one of the electrodes is retained within a certain range; and
(b) identifying an electric current consumption of the high voltage generating section on the basis of an on-time of the PWM signal.

According to the configurations, a PWM signal for controlling the high voltage generating section is generated by the signal generating section (in the step (a)). In addition, an electric current consumption of the high voltage generating section is identified by the identifying section (in the step (b)). That is, according to each of the electric current consumption identifying device in accordance with an aspect of the present invention and the electric current consumption identifying method in accordance with an aspect of the present invention, an electric current consumption of the high voltage generating section is identified by the signal generating section and the identifying section (through the steps (a) and (b)). This renders an ammeter unnecessary.

Therefore, with each of the electric current consumption identifying device in accordance with an aspect of the present invention and the electric current consumption identifying method in accordance with an aspect of the present invention, it is possible to reduce (i) the number of processes involved for inspection and (ii) production cost. Furthermore, with each of the electric current consumption identifying device in accordance with an aspect of the present invention and the electric current consumption identifying method in accordance with an aspect of the present invention, it is possible to identify an electric current consumption of the high voltage generating section without being affected by measurement accuracy of an ammeter. This makes it possible to produce a highly reliable result in a case where the electric current consumption is to be identified.

The electric current consumption identifying device in accordance with an aspect of the present invention can be configured so that the identifying section identifies an electric current consumption of the high voltage generating section in accordance with a relationship between an on-time of a PWM signal and an electric current consumption of the high voltage generating section which are associated with each other in advance.

According to the configuration, the on-time of the PWM signal and an electric current consumption of the high voltage generating section are associated with each other in advance. This allows the electric current consumption of the high voltage generating section to be easily identified by measuring the on-time of the PWM signal.

The electric current consumption identifying device in accordance with an aspect of the present invention can be configured so as to further include a reporting section for causing a report to be sent out, the report reporting that an electric current consumption of the high voltage generating section calculated by the calculating section is larger than a certain value.

For example, the certain value is defined in advance so that (i) the high voltage generating section is not a defective product if the electric current consumption is below the certain value and (ii) the high voltage generating section is a defective product if the electric current consumption is above the certain value. Hence, in the inspecting step of inspecting the high voltage generating section, for example, selection of high voltage generating sections which are good products from high voltage generating sections which are defective products can be easily made with a decision-making factor of whether or not the reporting section gives a report. This allows for a reduction in inspection cost.

Note that the electric current consumption identifying devices can each be achieved by a computer. In such a case, the scope of the present invention also encompasses (i) an inspection program for achieving, with the use of a computer, each of the electric current consumption identifying devices by causing the computer to serve as each of the sections and (ii) a computer-readable information recording medium in which the inspection program is recorded.

### [Supplemental Remarks]

An electrostatic atomizer in accordance with an aspect of the present invention can be configured so that the certain value of the on-time of the PWM signal is a value which corresponds, in a relationship between the on-time and an electric current consumption of the high voltage generating section which are associated with each other in advance, to a predetermined electric current consumption of the high voltage generating section.

According to the configuration, the certain time of the on-time of the PWM signal is associated with a predetermined electric current consumption.

For example, it is specified in advance that (i) in a case where an on-time of a PWM signal is below a certain value, high voltage generating section is a good product whose electric current consumption does not exceed a predetermined electric current consumption and (ii) in a case where the on-time of the PWM signal is above the certain value, the high voltage generating section is a defective product whose electric current consumption exceeds the predetermined electric current consumption. Hence, in the inspecting step of inspecting the electrostatic atomizer, for example, selection of high voltage generating sections which are good products from high voltage generating sections which are defective products can be easily made with a decision-making factor of whether or not the reporting section gives a report. This allows for a reduction in inspection cost.

The electrostatic atomizer in accordance with an aspect of the present invention can be configured so that: the identifying section includes a comparator and a timer; the comparator makes a comparison between a voltage of the PWM signal and a certain voltage corresponding to a threshold by which it is judged whether or not the PWM signal is in an on state, and then supplies a result of the comparison to the timer; and the timer measures an on-time of the PWM signal in accordance with the result supplied from the comparator.

With the configuration, the on-time of the PWM signal can be measured by an extremely simple arrangement. Note that a certain voltage corresponds to a threshold by which it is judged whether or not the PWM signal is in an on state, and is not limited to any particular value.

An electrostatic atomizer in accordance with an aspect of the present invention can be configured so that the identifying section includes a measuring section for measuring an on-time of a PWM signal during a certain time and a calculating section for calculating, in accordance with the relational formula, an electric current consumption of the high voltage generating section on the basis of the on-time measured by the measuring section.

According to the configuration, the calculating section uses, when calculating the electric current consumption of the high voltage generating section, a relational formula in which an on-time of a PWM signal during a certain time and an electric current consumption of the high voltage generating section are associated with each other. This makes it easy to calculate an electric current consumption. In addition, since the calculating section uses the relational formula, it is possible to reduce a computation load.

The electrostatic atomizer in accordance with an aspect of the present invention can be configured so that the report is sent out of the electrostatic atomizer via at least any one of the following: making sound; displaying on a display member; turning on light; and flashing light.

With the configuration, it is possible to cause a report to be clearly sent out, the report reporting that (i) the on-time of the PWM signal is larger than a certain value or (ii) an electric current consumption of the high voltage generating section is larger than a value specified in advance. Hence, in the inspecting step of inspecting the electrostatic atomizer, for example, selection of high voltage generating sections which are good products from high voltage generating sections which are defective products can be easily made with the report serving as a factor in making a decision. This allows for a reduction in inspection cost.

An electrostatic atomizer inspecting method in accordance with an aspect of the present invention can be configured so that the high voltage generating section includes an oscillator for converting, into an alternating current, a direct current supplied from a power supply, a transformer which is connected to the oscillator and which changes a volume of a voltage of the alternating current, and a converter circuit which is connected to the transformer and which converts an alternating current into a direct current, the method further includes the step of: judging, in accordance with the report sent out in the step (c), that at least any one of the oscillator, the transformer, and the converter circuit is defective.

It is empirical knowledge that an electric current consumption of an electrostatic atomizer can easily be affected by a high voltage generating section, particularly by a transformer. Therefore, by carrying out the method above, it is possible to narrow down, in a case where a report is given by the reporting section, parts which may be defective.

The present invention is not limited to the embodiments, but can be altered by a skilled person in the art within the scope of the claims. An embodiment derived from a proper combination of technical means each disclosed in a different embodiment is also encompassed in the technical scope of the present invention.

### Industrial Applicability

The present invention can be suitably applied to an electrostatic atomizer that sprays aromatic oil, a chemical substance for an agricultural product, a medicine, an agricultural chemical, a pesticide, an air cleaning agent, or the like.

### Reference Signs List

1 Spray electrode (first electrode)
2 Reference electrode (second electrode)
3 Power supply device
5 Tip
6 Spray electrode mounting section
7 Reference electrode mounting section
9 Inclined surface
10 Dielectric
11 Opening
12 Opening
21 Power supply
22 High voltage generating device
24 Control circuit (electric current consumption identifying device)
25 Microprocessor
26 Comparator
27 PWM signal generating section (signal generating section)
28 Identifying section
29 Measuring section
30 Calculating section
31 Comparator
32 Timer
33 Reporting section
100, 101, 102, 103 Electrostatic atomizer
221 Oscillator
222 Transformer
223 Converter circuit
231 Current feedback circuit

## Claims

1. An electrostatic atomizer which includes a first electrode and a second electrode and sprays a liquid from a tip of the first electrode by applying a high voltage between the first electrode and the second electrode,
the electrostatic atomizer comprising:
a high voltage generating section for applying a high voltage between the first electrode and the second electrode;
a signal generating section for generating a PWM signal (Pulse Width Modulation signal) for controlling the high voltage generating section so that an electric current at the second electrode is retained within a certain range;
an identifying section for identifying an on-time of the PWM signal during a certain time; and
a reporting section for causing a report to be sent out of the electrostatic atomizer in a case where the on-time identified by the identifying section is larger than a certain value, the report reporting that the on-time identified by the identifying section is larger than the certain value.

2. The electrostatic atomizer as set forth in claim 1, wherein
the certain value of the on-time of the PWM signal is a value which corresponds, in a relationship between the on-time and an electric current consumption of the high voltage generating section which are associated with each other in advance, to a predetermined electric current consumption of the high voltage generating section.

3. The electrostatic atomizer as set forth in claim 1 or 2, wherein:
the identifying section includes a comparator and a timer;
the comparator makes a comparison between a voltage of the PWM signal and a certain voltage corresponding to a threshold by which it is judged whether or not the PWM signal is in an on state, and then supplies a result of the comparison to the timer; and
the timer measures an on-time of the PWM signal in accordance with the result supplied from the comparator.

4. The electrostatic atomizer as set forth in any one of claims 1 through 3, wherein
the report is sent out of the electrostatic atomizer via at least any one of the following: making sound; displaying on a display member; turning on light; and flashing light.

5. An electrostatic atomizer which includes a first electrode and a second electrode and sprays a liquid from a tip of the first electrode by applying a high voltage between the first electrode and the second electrode,
the electrostatic atomizer comprising:
a high voltage generating section for applying a high voltage between the first electrode and the second electrode;
a signal generating section for generating a PWM signal (Pulse Width Modulation signal) for controlling the high voltage generating section so that an electric current at the second electrode is retained within a certain range;
an identifying section for identifying an electric current consumption of the high voltage generating section on the basis of an on-time of the PWM signal during a certain time in accordance with a relational formula in which an on-time of the PWM signal during a certain time and an electric current consumption of the high voltage generating section are associated with each other; and
a reporting section for causing a report to be sent out of the electrostatic atomizer in a case where the electric current consumption of the high voltage generating section identified by the identifying section is larger than a value specified in advance, the report reporting that the electric current consumption of the high voltage generating section identified by the identifying section is larger than the value specified in advance.

6. The electrostatic atomizer as set forth in claim 5, wherein
the identifying section includes
a measuring section for measuring an on-time of the PWM signal during a certain time and
a calculating section for calculating, in accordance with the relational formula, an electric current consumption of the high voltage generating section on the basis of the on-time measured by the measuring section.

7. The electrostatic atomizer as set forth in claim 5 or 6, wherein
the report is sent out of the electrostatic atomizer via at least any one of the following: making sound; displaying on a display member; turning on light; and flashing light.

8. A method for inspecting an electrostatic atomizer including a first electrode and a second electrode and spraying a liquid from a tip of the first electrode by applying a high voltage between the first electrode and the second electrode,
the electrostatic atomizer comprising:
a high voltage generating section for applying a high voltage between the first electrode and the second electrode,
the method comprising the steps of:
(a) generating a PWM signal (Pulse Width Modulation signal) for controlling the high voltage generating section so that an electric current at the second electrode is retained within a certain range;
(b) identifying an on-time of the PWM signal during a certain time; and
(c) causing a report to be sent out of the electrostatic atomizer in a case where the on-time identified in the step (b) is larger than a certain value, the report reporting that the on-time identified in the step (b) is larger than the certain value.

9. The method as set forth in claim 8, wherein
the high voltage generating section includes
an oscillator for converting, into an alternating current, a direct current supplied from a power supply,
a transformer which is connected to the oscillator and which changes a volume of a voltage of the alternating current, and
a converter circuit which is connected to the transformer and which converts an alternating current into a direct current,
the method further comprises the step of:
judging, in accordance with the report sent out in the step (c), that at least any one of the oscillator, the transformer, and the converter circuit is defective.

10. An inspection program for inspecting an electrostatic atomizer including a first electrode and a second electrode and spraying a liquid from a tip of the first electrode by applying a high voltage between the first electrode and the second electrode,
the electrostatic atomizer comprising:
a high voltage generating section for applying a high voltage between the first electrode and the second electrode,
the inspection program causing a computer to carrying out the following steps:
(a) generating a PWM signal (Pulse Width Modulation signal) for controlling the high voltage generating section so that an electric current at the second electrode is retained within a certain range;
(b) identifying an on-time of the PWM signal during a certain time; and
(c) causing a report to be sent out of the electrostatic atomizer in a case where the on-time identified in the step (b) is larger than a certain value, the report reporting that the on-time identified in the step (b) is larger than the certain value.

11. A computer-readable information recording medium in which the inspection program recited in claim 10 is recorded.
